# EUROPÄISCHE PATENTSCHRIFT

(11) **EP 2 483 602 B1**
(45) Veröffentlichungstag und Bekanntmachung des Hinweises auf die Patenterteilung: **22.08.2018**
(21) Anmeldenummer: 10765411.3
(22) Anmeldetag: 01.10.2010
(51) Int. Cl.: E05F 15/73, F24C 15/02, G01R 27/26

(54) **TÜRVORRICHTUNG FÜR EIN HAUSGERÄT, HAUSGERÄT MIT EINER DERARTIGEN TÜRVORRICHTUNG SOWIE VERFAHREN ZUM BETÄTIGEN EINER TÜRVORRICHTUNG FÜR EIN HAUSGERÄT**
DOOR DEVICE FOR A HOUSEHOLD APPLIANCE, HOUSEHOLD APPLIANCE COMPRISING SUCH A DOOR DEVICE AND METHOD FOR ACTUATING A DOOR DEVICE FOR A HOUSEHOLD APPLIANCE
DISPOSITIF DE PORTE D'UN APPAREIL ÉLECTROMÉNAGER, APPAREIL ÉLECTROMÉNAGER ÉQUIPÉ DUDIT DISPOSITIF DE PORTE ET PROCÉDÉ PERMETTANT D'ACTIONNER UN DISPOSITIF DE PORTE D'UN APPAREIL ÉLECTROMÉNAGER

(30) Priorität: 02.10.2009 EP 09290772
(43) Veröffentlichungstag der Anmeldung: 08.08.2012
(73) Patentinhaber: BSH Hausgeräte GmbH, 81739 München (DE)
(72) Erfinder: MOLLET, Gael, F-67120 Duttlenheim (FR); STEINER, Pierre, F-67310 Wasselonne (FR); BECKER, Jeremy, F-57730 Petit Ebersviller (FR)
(86) Internationale Anmeldenummer: PCT/EP2010/064680
(87) Internationale Veröffentlichungsnummer: WO 2011/039362

(56) Entgegenhaltungen:
- WO-A1-2006/133998
- DE-A1- 10 235 361
- DE-A1-102006 029 902
- DE-A1-102006 059 208
- DE-A1-102009 026 670
- DE-U1-202006 016 122
- JP-A- 8 232 529
- JP-A- 2005 326 044
- US-A1- 2006 107 597
- US-A1- 2007 267 402
- US-A1- 2008 282 504
- US-A1- 2008 288 113
- US-B1- 6 307 182

## Beschreibung

Die Erfindung betrifft eine Türvorrichtung für ein Hausgerät, mit einer Tür, einem Griffelement und mit einer Türöffnungsvorrichtung zum automatischen Öffnen der Tür ausgebildet ist. Des Weiteren betrifft die Erfindung ein Hausgerät, insbesondere einen Backofen, mit einer derartigen Türvorrichtung sowie ein Verfahren zum Betätigen der Türvorrichtung für ein Hausgerät.

Türvorrichtungen für Hausgeräte, wie beispielsweise Backöfen, Mikrowellengeräte, Gefrierschränke, Kühlschränke oder dergleichen sind in vielfältiger Weise bekannt. Die Türen sind in diesem Zusammenhang zum Verschließen eines Garraums oder eines sonstigen Lagerraums vorgesehen. In diesem Zusammenhang sind Türen bekannt, welche an einer Frontplatte frontseitig zumindest ein Griffelement aufweisen, welches von einem Nutzer gegriffen werden kann und manuell betätigt werden kann, so dass die Tür geöffnet werden kann. Derartige Griffelemente stehen üblicherweise nach vorne über, so dass sie zum einen Platz benötigen und zum anderen kann sich ein Nutzer daran stoßen. Darüber hinaus muss bei derartigen ausschließlich manuell betätigbaren Griffelementen gegebenenfalls ein relativ hoher Krafteinsatz aufgewendet werden, um das Öffnen gewährleisten zu können.

Des Weiteren sind automatische Türöffnungsvorrichtungen bei Türvorrichtungen zum Öffnen der Tür vorgesehen. Beispielsweise ist hier vorgesehen, dass durch ein Drücken eines Betätigungselements oder einer Öffnungstaste die Tür entriegelt wird und automatisch geöffnet wird beziehungsweise aufspringt. Beim Versagen des besagten Betätigungsmechanismus oder der dazu erforderlichen Elektronik, ist das Öffnen nur noch durch ein Servicepersonal oder einen Kundendienst möglich. Des Weiteren ist bei derartigen elektronisch gesteuerten Türöffnungsvorrichtungen, die über eine frontseitig angeordnete Bedientaste durch einen Nutzer betätigbar sind, kein weiteres explizites Griffelement mehr vorgesehen. Die Handhabbarkeit ist daher nutzerunfreundlich. Zum vollständigen Öffnen muss daher der Nutzer explizit die Frontplatte oder die üblicherweise nicht primär zum Greifen vorgesehenen Bereiche der Tür berühren und die Tür ganz öffnen. Dadurch wird die Tür durch Fingerspuren und dergleichen verunreinigt und muss auch aufgrund hygienischer Bedingungen daher häufig gewischt und gereinigt werden.

Die US 2006/0107597 A1 offenbart einen Kühlschrank, eine Türöffnungsvorrichtung sowie ein Verfahren hierfür, wobei dieses Dokument den nächstliegenden Stand der Technik offenbart. Darüber hinaus offenbart die JP 2005-326044 A eine Vorrichtung zum Öffnen und Schließen einer Tür oder eine Türschließvorrichtung für einen Kühlschrank.

Schließlich offenbart die WO 2006/133998 A1 eine Hausgerätetür.

Weiterer relevanter Stand der Technik ist aus US 2008/0282504 A1, DE 102 35 361 A1, DE 20 2006 016 122 U1 und DE 10 2009 026 670 A1 bekannt. Des Weiteren weisen die bisher bekannten elektronisch gesteuerten Türöffnungsvorrichtungen einen sehr komplexen Aufbau auf und sind in ihrer Reaktionszeit relativ langsam.

Es ist Aufgabe der vorliegenden Erfindung, eine Türvorrichtung für ein Hausgerät sowie ein derartiges Hausgerät mit einer Türvorrichtung als auch ein Verfahren zum Betätigen einer Türvorrichtung zu schaffen, mit welcher beziehungsweise mit welchem die Öffnungszeiten beim automatischen Öffnen der Tür reduziert werden und darüber hinaus die Nutzerfreundlichkeit im Hinblick auf ausreichende Griffsicherheit und platzsparenden Aufbau der Türvorrichtung gewährleistet ist.

Diese Aufgabe wird durch eine Türvorrichtung, welche die Merkmale nach Anspruch 1 aufweist, ein Hausgerät, welches die Merkmale nach Anspruch 13 aufweist, sowie ein Verfahren, welches die Merkmale nach Anspruch 14 aufweist, gelöst.

Eine erfindungsgemäße Türvorrichtung für ein Hausgerät umfasst eine Tür und ein Griffelement zum Greifen beim Bewegen der Tür durch einen Nutzer. Des Weiteren umfasst die Türvorrichtung eine Türöffnungsvorrichtung zum automatischen Öffnen der Tür. Die Tür weist zumindest einen Erkennungssensor auf, welcher zur Erfassung eines Fingers in einem Detektionsbereich um das oder an dem oder einem Griffelement ausgebildet ist, und es ist eine Steuereinheit ausgebildet, welche abhängig von den Informationen des Erkennungssensors zur Steuerung der Türöffnungsvorrichtung ausgebildet ist. Erfindungsgemäß ist die Tür mit einer ersten vertikalen Längsseite, mit einer der ersten Längsseite gegenüberliegenden zweiten vertikalen Längsseite und mit einer sich zwischen den Längsseiten erstreckenden Oberseite ausgebildet. Erfindungsgemäß ist an der zweiten Längsseite ein Griffelement und/oder an der Oberseite ein Griffelement ausgebildet.

Hierbei ist an der zweiten Längsseite und/oder der Oberseite der Tür ein Schlitz ausgebildet, in dem das Griffelement angeordnet ist. Durch eine derartig zumindest teilweise versenkte Anordnung kann eine noch platzsparendere und bauraumminimiertere Ausgestaltung erreicht werden. Zum anderen kann es dadurch mechanisch stabil angebracht werden.

In sehr spezieller Positionierung ist das Griffelement nicht an der Frontseite der Tür angebracht, sondern in quasi bauraumminimierter und platzsparender Ausgestaltung an der zweiten vertikalen Längsseite und/oder an der Oberseite. Da die Tür eine gewisse Dicke aufweist, ist diese zweite Längsseite und/oder die Oberseite und die damit verbundene Dicke geeignet das Griffelement aufzunehmen, so dass sich diesbezüglich die Dicke der Tür durch das Griffelement nicht ändert. Eine Längsseite ist daher durch die Fläche definiert, welche sich durch die Dicke der Tür hinter der Frontfläche der Tür nach hinten ergibt. Analog gilt dies für die Oberseite. Darüber hinaus kann durch diese spezielle Positionierung des Griffelements an der Längsseite und/oder der Oberseite auch verhindert werden, dass sich Personen daran stoßen, wie dies bei Griffelementen, die sich von der Frontseite nach vorne erheben oder dergleichen, der Fall ist. Darüber hinaus ist diese spezifische Position des Griffelements auch eine sehr nutzerfreundliche Anbringung, die gerade im Hinblick auf das ohnehin vorgesehene und intuitive Öffnen und Greifen der Tür an der richtigen Seite den Nutzer quasi intuitiv an die richtige Stelle führt. Indem explizit ein Griffelement zum Greifen mit den Fingern ausgebildet ist, kann auch eine Ausgestaltung geschaffen werden, bei der ein unerwünschtes Angreifen von oder Entlanggleiten an anderen Teilen der Türe mit den Fingern oder der Hand vermieden werden kann, so dass deren Verschmutzung durch die menschliche Hand verhindert werden kann. Nicht zuletzt kann durch dieses explizite Griffelement auch eine sehr ergonomische, angepasste Greifmöglichkeit geschaffen werden, welche ein Abrutschen oder dergleichen verhindert, so dass auch diesbezüglich eine nutzerfreundliche berührungslos zu dem Griffelement gebrachten Finger erkannt wird, so dass ein Öffnungswunsch durch den Nutzer sehr schnell und frühzeitig detektiert wird und somit auch die Türöffnungsvorrichtung wesentlich schneller angesteuert werden kann. Die Reaktionszeit der automatischen Türöffnungsvorrichtung kann dadurch deutlich reduziert werden und auf eine Öffnungsdauer kleiner 0,5 Sekunden reduziert werden.

Vorzugsweise ist an der ersten Längsseite zumindest ein Anschlagelement zum Verschwenken der Tür parallel zur Längsseite anbringbar. Es wird also insbesondere eine

Ausgestaltung zum sicheren weiteren Öffnen und Bewegen der Tür durch einen Nutzer nach der automatischen Öffnung gewährleistet ist. Es ist der zumindest eine Erkennungssensor vorgesehen, durch welchen sehr schnell und zeitnah das Berühren, Greifen oder zumindest in einem nahen Umfeld berührungslos zu dem Griffelement gebrachten Finger erkannt wird, so dass ein Öffnungswunsch durch den Nutzer sehr schnell und frühzeitig detektiert wird und somit auch die Türöffnungsvorrichtung wesentlich schneller angesteuert werden kann. Die Reaktionszeit der automatischen Türöffnungsvorrichtung kann dadurch deutlich reduziert werden und auf eine Öffnungsdauer kleiner 0,5 Sekunden reduziert werden.

Vorzugsweise ist an der ersten Längsseite zumindest ein Anschlagelement zum Verschwenken der Tür parallel zur Längsseite anbringbar. Es wird also insbesondere eine Türvorrichtung vorgesehen, bei welcher die Tür zum seitlichen Anschlagen ausgebildet ist, so dass die Tür um eine vertikale Längsachse zum Öffnen und Schließen bewegt werden kann.

Vorzugsweise ist das Griffelement als stabiles Teil ausgebildet, welches einstückig konzipiert ist. Insbesondere ist vorgesehen, dass das Griffelement ortsfest und somit nicht relativ bewegbar zur Tür an der zweiten Längsseite und/oder der Oberseite angeordnet ist. Es ist also nicht vorgesehen, dass das Griffelement durch eine relative Bewegbarkeit zur Tür einen gewissen Öffnungsmechanismus in Gang setzt. Das Griffelement dient somit lediglich dem Greifen.

Vorzugsweise ist das Griffelement eine insbesondere geradlinige Leiste, die einen Eingriffsbereich, insbesondere eine eckenfreie Rinne entsprechend einer Griffmulde aufweist. Eine derartige Ausgestaltung ist eine besonders ergonomische Formgebung, die es besonders leichtgängig erlaubt mit den Fingern einzugreifen und durch wenig Kraftaufwand die Tür nach dem automatischen Öffnen manuell weiterzuöffnen. Auch hier kann somit ein Abrutschen und aufgrund der eckenfreien Ausgestaltung ein sich Verletzen oder daran Hängenbleiben vermieden werden. Nicht zuletzt kann durch eine derartige Ausgestaltung bereits durch eine relativ seichte Mulde ein ausreichender Griffbereich gebildet sein.

Vorzugsweise ist ein einer Türfront zugewandter Rinnenschenkel länger ausgebildet als ein der Türfront abgewandter Rinnenschenkel. Durch diese im Hinblick auf die Mulde unsymmetrische Ausgestaltung der Schenkel beziehungsweise Wände kann auch hier einem möglichst präzisen und haltestabilen Eingreifen Rechnung getragen werden. Dies ermöglicht zum einen einen größeren Bereich, mit dem man mit den Fingern in den Eingriffsbereich gelangen kann, so dass auch hier die Zugänglichkeit zum Eingriffsbereich verbessert ist. Zum anderen kann auch hier die Bauraumtiefe an der der Türfront abgewandten Seite vermindert werden, so dass unerwünschte Anschläge an weiteren Komponenten des Hausgeräts vermieden werden können.

Vorzugsweise ist das Griffelement bei frontseitiger Betrachtung der Tür hinter einer Frontplatte der Tür angeordnet und durch diese verdeckt. Dies ist eine besonders geschützte Anordnung, so dass auch ein daran Anstoßen vermieden werden kann und darüber hinaus auch ein unerwünschter Verschleiß oder eine Beschädigung des Griffelements vermieden werden kann. Nicht zuletzt kann dadurch auch hohen Qualitäts- und Designansprüchen Rechnung getragen werden, da bei einer frontseitigen Betrachtung das Griffelement nicht eingesehen werden kann.

Vorzugsweise ist der zumindest eine Erkennungssensor ein kapazitiver Sensor. Dieser ermöglicht eine sehr schnelle Erfassung eines Fingers in einem Detektionsbereich oder an dem Griffelement selbst und ist darüber hinaus funktionell relativ robust ausgebildet.

Vorzugsweise ist in der Tür hinter dem Griffelement, insbesondere an dem Griffelement hinter einem Eingriffsbereich, zumindest eine Elektrode des kapazitiven Sensors angeordnet. Dadurch kann eine besonders genaue und besonders sensitive Detektion ermöglicht werden. Darüber hinaus ist durch diese spezifische örtliche Positionierung der Elektrode auch eine sehr geschützte und verschleißarme Position gegeben. Nicht zuletzt kann durch diese Position auch bei einer zerstörungsfrei lösbaren Anbringung des Griffelements an der Längsseite eine einfache Zugänglichkeit zur Elektrode zu Austausch- oder Wartungszwecken ermöglicht werden.

Vorzugsweise ist das Griffelement zumindest im Bereich des Erkennungssensors aus einem elektrisch nicht leitenden Material ausgebildet.

Der Erkennungssensor kann auch ein induktiver Sensor oder ein Mikroschalter sein.

Insbesondere ist die automatische Türöffnungsvorrichtung mit einer Kindersicherungseinrichtung ausgebildet. Dies ist ein besonderer Vorteil, da dadurch ein unerwünschtes automatisches Öffnen der Tür beim Greifen in das Griffelement durch ein Kind vermieden werden kann. Gerade bei Hausgeräten, wie Backöfen oder dergleichen, die relativ hohe Temperaturen im Betrieb im Garraum aufweisen, welcher mit der Tür verschlossen ist, kann somit ein hohes Sicherheitspotential für Kinder geschaffen werden.

Vorzugsweise weist die Tür eine Bedieneinrichtung auf, welche an einer Frontplatte der Tür ausgebildet ist. Durch diese türintegrierte Anordnung der Bedieneinrichtung ist wiederum eine vorteilhafte kompakte Ausgestaltung und benutzerfreundliche Anordnung geschaffen, welche übersichtlich und jederzeit zugänglich ist.

Besonders bevorzugt ist vorgesehen, dass die Kindersicherungseinrichtung über die Bedieneinrichtung elektronisch gesteuert durch die Steuereinheit aktivierbar und deaktivierbar ist. Somit kann schnell und zuverlässig diese Kindersicherungseinrichtung betätigt werden. Darüber hinaus kann die Bedieneinrichtung eine Anzeigeeinrichtung aufweisen, durch welche unterschiedlichste Informationen dem Nutzer präsentiert werden können. Indem die Anzeigeeinheit der Bedieneinrichtung ebenfalls in die Tür integriert und insbesondere an der Frontplatte ausgebildet ist, ist die Einsehbarkeit für einen Nutzer besonders groß. In diesem Zusammenhang kann gerade die Anzeige einer aktivierten oder deaktivierten Kindersicherungseinrichtung somit schnell und zuverlässig von einem Erwachsenen erkannt werden.

Vorzugsweise ist die Türöffnungsvorrichtung auch über die Bedieneinrichtung betätigbar. Durch eine derartige redundante Ausgestaltung der Türöffnungsmöglichkeit kann dann, wenn die Öffnungsmöglichkeit über das Griffelement ausfällt oder nicht uneingeschränkt zugänglich ist, auch über die Bedieneinrichtung folgen.

Besonders vorteilhaft ist dies dann, wenn zwei Hausgeräte mit einer derartigen Türöffnungsvorrichtung unmittelbar nebeneinander positioniert sind und die beiden einander zugewandten vertikalen Längsseiten im Wesentlichen unmittelbar aneinander anliegen.

Vorzugsweise ist die Aktivierung der Türöffnungsvorrichtung, insbesondere eines Motors, durch die Steuereinheit abhängig von einem Erkennen eines Betriebszustandes des Hausgeräts, insbesondere in einem nicht aktivierten Pyrolysebetrieb des Backofens, und/oder eines elektronisch erfassten Erkennens einer Sperrstellung eines Nockenelements einer Antriebsvorrichtung der Türöffnungsvorrichtung und/oder einer geschlossenen Tür. Auch dadurch können die Sicherheitsvorkehrungen im Hinblick auf ein unerwünschtes Öffnen der Tür erhöht werden.

Durch die zwei Möglichkeiten einer Türöffnung, zum einen über das Griffelement und zum anderen über die Bedieneinrichtung, kann diesbezüglich vorgesehen sein, dass dies über die Bedieneinrichtung und dieser zugeordneter Bedienelemente konfigurierbar ist. Nutzerindividuell kann somit auch eingestellt werden, durch welche der beiden Möglichkeiten eine Betätigung der automatischen Türöffnungsvorrichtung erfolgen soll. Auch dadurch kann der Kundennutzen deutlich erhöht werden.

Diesbezüglich ist die Steuereinheit der Türvorrichtung entsprechend ausgebildet und die individuell durch einen Nutzer eingestellte Konfiguration kann darin abgespeichert werden, bis sie gegebenenfalls wieder geändert wird.

Vorzugsweise weist die Türöffnungsvorrichtung der Türvorrichtung einen Türhaken auf, welcher an der Tür angeordnet ist, und welcher mittels einer separat zur Tür angeordneten Antriebsvorrichtung der Türöffnungsvorrichtung linear betätigbar und mit einer Antriebsvorrichtung seitig angeordneten Drehfalle zum Öffnen der Tür entriegelbar ist. Durch die lineare Betätigung des Türhakens kann das Öffnen sehr zuverlässig und ohne ein Verklemmen oder Verspreizen erfolgen. Da die Drehfalle im Hinblick auf ihre Bewegung komplexer ist, nämlich eine Linear- und eine Drehbewegung durchführt, wäre das Einwirken auf die Drehfalle im Öffnen der Tür aufwändiger. Durch das Einwirken auf den Türhaken und dessen Linearbewegung kann die Fehleranfälligkeit der automatischen Türöffnungsvorrichtung deutlich reduziert werden.

Des Weiteren betrifft die Erfindung ein Hausgerät, insbesondere einen Backofen mit einer Türvorrichtung gemäß der Erfindung oder einer vorteilhaften Ausgestaltung davon.

Vorteilhafte Ausführungen der erfindungsgemäßen Türvorrichtung sind als vorteilhafte Ausführungen des Hausgeräts anzusehen.

Des Weiteren betrifft die Erfindung ein Verfahren zum Betätigen einer Türvorrichtung für ein Hausgerät, mit einer Tür und einem Griffelement, wobei darüber hinaus die Türvorrichtung eine Türöffnungsvorrichtung zum automatischen Öffnen der Tür aufweist. Durch das erfindungsgemäße Verfahren wird ein Finger in einem Detektionsbereich um ein oder an einem Griffelement durch zumindest einen Erkennungssensor der Türvorrichtung erfasst und das Öffnen der Tür abhängig von den Informationen des Erkennungssensors durch eine Steuereinheit gesteuert.

Vorteilhafte Ausführungen der erfindungsgemäßen Türvorrichtung sind als vorteilhafte Ausführungen des erfindungsgemäßen Verfahrens anzusehen.

Im Hinblick auf die spezifische Ausgestaltung der Türöffnungsvorrichtung ist diese zum automatischen Öffnen der Tür des Hausgeräts ausgebildet. Insbesondere weist die Türöffnungsvorrichtung einen Antriebsmotor auf, welcher über eine Betätigungseinrichtung der Türöffnungsvorrichtung mit einem Türhaken mechanisch gekoppelt ist. Der Antriebsmotor ist mit einem Nockenelement der Betätigungseinrichtung gekoppelt, welches eine helixförmige Nockenbahn aufweist, an welche ein Übertragungselement der Betätigungseinrichtung anliegt, das mit dem Türhaken gekoppelt ist und mit welchem die Bewegung des Nockenelements auf den Türhaken übertragbar ist. Durch eine derartige spezifische Ausgestaltung der Türöffnungsvorrichtung mit den spezifischen Ausgestaltungen der Elemente und dem Zusammenwirken kann eine rotatorische Bewegung des Antriebsmotors, insbesondere dessen Welle, in eine Linearbewegung des Türhakens zum Öffnen der Tür umgewandelt werden. Durch die sehr spezifische Ausgestaltung des Nockenelements mit der helixförmigen Nockenbahn kann diese Bewegungsumwandlung besonders ruckfrei und gleichmäßig erfolgen, so dass auch hier unerwünschte Bewegungen verhindert werden können. Somit kann das Auftreten hoher Drehmomente oder Krafteinwirkungen auf die Komponenten beim Öffnen vermieden werden, so dass der Verschleiß der Türöffnungsvorrichtung deutlich reduziert werden kann. Nicht zuletzt kann durch diese helixförmige beziehungsweise gewundene Bahn der Nocke eine besonders präzise, dosierte und genaue Bewegungsführung ermöglicht werden.

Vorzugsweise ist das Nockenelement durch den Antriebsmotor um seine Längsachse drehbar und die Drehbewegung ist durch die helixförmige Nockenbahn in eine Linearbewegung übergeführt, durch welche der Türhaken zum Öffnen der Tür linear bewegbar ist.

Gerade dies ermöglicht ein Betätigungskonzept, bei dem möglichst wenig Bauteile verwendet werden, und darüber hinaus eine zuverlässige Unwandlung der Bewegungsrichtungen über die gekoppelten Elemente erreicht ist. Die lineare Bewegungsführung des Türhakens ermöglicht eine gegenüber einem direkten Einwirken auf eine Drehfalle der Türöffnungsvorrichtung eine robustere und viel freiere Öffnungsmöglichkeit. Ein Verklemmen, Verspreizen oder unerwünschtes Verdrehen kann dadurch verhindert werden und ein Sperren des Türöffnens vermieden werden.

Vorzugsweise ist die Drehstellung des Nockenelements durch einen elektronischen Schalter erfassbar. Dadurch kann die Bewegungsführung noch präziser im Hinblick auf die genaue Steuerung erfolgen.

Die Tür kann jederzeit auch manuell geöffnet werden. Dadurch kann auch beispielsweise bei einem Stromausfall die Tür geöffnet werden und sicherheitskritische zustände können vermieden werden.

Vorzugsweise weist das Nockenelement ein erstes Drehstellungsintervall auf. Befindet sich das Nockenelement relativ zu einem Positionserkennungsschalter in diesem ersten Drehstellungsintervall, so wird eine Position des Nockenelements erkannt, welche ein vollständiges Schließen der Tür erlaubt. Da das Nockenelement mit dem Motor gekoppelt ist, wird dadurch auch eine Position des Motors erkannt, bei welcher er quasi seine Nullstellung erreicht hat. Der Motor wird also, insbesondere nach dem Öffnen der Tür, solange wieder zurück gedreht bis er seine Nullstellung wieder erreicht hat, um dann irgendwann nachfolgend die geöffnete Tür wieder vollständig manuell schließen zu können. Dadurch wird hohen Sicherheitsanforderungen Rechnung getragen, da der Motor und somit auch das Nockenelement nicht in unerwünschten Position stehen bleiben, in denen ein vollständiges Schließen der Tür nicht mehr möglich wäre. Gerade dann, wenn diese Position gerade so wäre, dass von einem Nutzer nicht ohne weiteres erkannt werden kann, ob die Tür vollständig geschlossen ist oder nicht, könnten dann sicherheitskritische Zustände, beispielsweise bei einem Pyrolysebetrieb eine Backofens auftreten. Dies wird durch diese Ausführung vermieden.

Besonders bevorzugt ist vorgesehen, dass ein Zurückdrehen des Motors und des Nockenelements von der Endstellung in die Nullstellung bzw. Grundstellung dahingehend erfolgt, dass eine Drehung weiter in die Richtung erfolgt, in welcher das Nockenelement von der Nullstellung in die Endstellung bewegt wurde. Dies bedeutet, dass die Motorwelle nur immer in eine Drehrichtung weiter gedreht wird. Bei einem Überführen des Nockenelements von der Nullstellung in die Endstellung wird also in die gleiche Richtung gedreht wie beim nachfolgenden Überführen von der Endstellung in die Nullstellung. Durch diese lediglich eine Drehrichtungsmöglichkeit des Motors und des Nockenelements kann das Ansteuern des Motors durch die Steuereinheit wesentlich einfacher und dadurch auch mit geringerem Aufwand und geringerer Fehleranfälligkeit erreicht werden.

Vorzugsweise ist an einer Außenseite des Nockenelements eine Erhebung ausgebildet, welche durch einen elektronischen Schalter zum Erkennen der Drehstellung des Nockenelements erfassbar ist. Durch diese Erhebung an der Mantelfläche des Nockenelements und dem dazu beabstandet positionierten elektronischen Schalter kann diese Veränderung der Mantelfläche detektiert werden und jederzeit zuverlässig erkannt werden, in welcher Drehstellung sich das Nockenelement befindet.

Nicht zuletzt kann durch diese spezifischen Ausgestaltung zur Positionserkennung eine sehr robuste und bauteilreduzierte Ausgestaltung erreicht werden, welche darüber hinaus auch noch besonders kompakt aufgebaut ist. Denn das Ausbilden der Erhebung erfolgt im Wesentlichen durch einstückige Ausgestaltung des Nockenelements, so dass die Erhebung auch besonders positionsstabil und verschleißarm ausgebildet und angeordnet ist.

Nicht zuletzt ist dadurch eine sehr bauteilreduzierte Ausgestaltung möglich.

Vorzugsweise weist das Nockenelement ein zweites Drehstellungsintervall auf. Insbesondere erstreckt sich dieses zweite Drehstellungsintervall von der ersten Drehzwischenstellung bis zu einer Endstellung. Insbesondere werden somit über die gesamte Drehbewegungsmöglichkeit des Elements zwei Drehstellungsintervalle beziehungsweise zwei Zonen gebildet.

Vorzugsweise ist die vom zweiten Drehstellungsintervall umfasste Länge der Nockenbahn wesentlich länger, insbesondere um ein Vielfaches, wie die vom ersten Drehstellungsintervall umfasste Länge der Nockenbahn. Durch eine derartige spezifische Längendimensionierung ist der präzise geführten Bewegung des Übertragungselements auf der Nockenbahn Rechnung getragen und das sehr genaue Erkennen von Stellungen zum vollständigen Schließen der Tür ermöglicht.

Vorzugsweise ergeben die zusammengefügten Längen der Drehstellungsintervalle der helixförmigen Nockenbahn eine volle Umdrehung um die Längsachse des Nockenelements. Die Drehmöglichkeit des Nockenelements um seine Drehachse entspricht daher vorzugsweise einer einzigen vollen Umdrehung. Durch eine derartige Ausgestaltung kann in besonders vorteilhafter Weise erreicht werden, dass keine zu schnellen Drehbewegungen im Hinblick auf die volle Linearbewegung des Türhakens erfolgen müssen, so dass ein Abrutschen des Übertragungselements von der Nockenbahn verhindert werden kann. Darüber hinaus kann durch diese Ausgestaltung auch der Verschleiß besonders niedrig gehalten werden und eine besonders geführte und ruckfreie Bewegung des Türhakens gewährleistet werden.

Nicht zuletzt treten dadurch möglichst geringe Drehmomente auf, so dass auch hier das Zusammenspiel der Komponenten besonders verschleißarm erfolgen kann.

Vorzugsweise umfasst das Übertragungselement ein Kugellager. Darüber hinaus ist vorgesehen, dass zwischen einem Motorträger und dem Nockenelement ein Längskugellager angeordnet ist. Durch diese Anordnung und die spezifische Ausgestaltung mit einem Längskugellager kann das Auftreten von Axialkräften auf die Antriebswelle des Motors vermieden werden. Die radiale Kraft auf die Antriebswelle des Motors ist dadurch ebenfalls sehr gering.

Insbesondere ist nur der Türhaken an der Tür angeordnet und die weiteren Komponenten der Türöffnungsvorrichtung sind an dem Hausgerät selbst und nicht an der Tür angeordnet. Vorzugsweise sind die nicht an der Tür angeordneten Komponenten an einem unteren Verschluss des Hausgeräts zum Öffnen und Schließen der Tür angeordnet. Insbesondere ist durch die Linearbewegung des Türhakens beim Öffnen der Tür ein verriegelter Zustand zwischen dem Türhaken und einer Drehfalle lösbar.

Die Türöffnungsvorrichtung funktioniert insbesondere dahingehend, dass der Antriebsmotor durch die Steuereinheit angesteuert wird und die mit der Antriebswelle des Motors gekoppelte Nocke beziehungsweise des Nockenelement dreht sich entsprechend.

Durch diese Drehbewegung dreht sich auch die helixförmige Nockenbahn und ein damit kontaktiertes Übertragungselement, im speziellen ein Kugellager, rollt entlang dieser helixförmigen Nockenbahn. Dieses Kugellager ist an einem Stößel befestigt, der direkt auf den Türhaken drückt, wobei sich der Stößel in dem Gehäuse der Türöffnungsvorrichtung verschiebt. Dadurch wird auch der Türhaken in lediglich linearer Richtung verschoben und der verriegelte Zustand mit einer Drehfalle wird geöffnet. Des Weiteren ist vorgesehen, dass der Antriebsmotor schnell gestoppt werden kann, indem er kurz geschlossen wird. Dadurch kann eine gute Nockenpositionseinstellung ermöglicht werden, da das System sehr schnell reagiert und quasi keinen Nachlauf hat. Darüber hinaus kann ein sehr schnelle Deaktivieren erreicht werden, wenn beispielsweise die Tür blockiert wird indem sie beispielsweise zugehalten wird oder eine Person daran angelehnt ist. Dabei kann die elektrische Versorgung des Motors begrenzt sein beziehungsweise der Strom im Motor beispielsweise durch einen Reihenwiderstand, begrenzt sein. Eine Beschädigung des Motors kann dadurch verhindert werden und jederzeit ein schnelles Abschalten ermöglicht werden.

Ein Ausführungsbeispiel der Erfindung wird nachfolgend anhand schematischer Zeichnungen näher erläutert. Es zeigen:
- Fig. 1: eine perspektivische Darstellung eines erfindungsgemäßen Hausgeräts mit geöffneter Tür;
- Fig. 2: eine perspektivische Darstellung eines Griffelements einer Türvorrichtung;
- Fig. 3: eine schematische Schnittdarstellung der Tür gemäß Fig. 1 im Bereich des Griffelements;
- Fig. 4: eine perspektivische Darstellung eines Ausführungsbeispiels einer Türöffnungsvorrichtung;
- Fig. 5: eine perspektivische Ansicht von unten der Türöffnungsvorrichtung gemäß Fig. 4;
- Fig. 6: eine Darstellung der Türöffnungsvorrichtung von unten in der Grundstellung des Nockenelements; und
- Fig. 7: eine vergrößerte Darstellung eines Teilausschnitts der Türöffnungsvorrichtung gemäß Fig. 4.

In den Figuren werden gleiche oder funktionsgleiche Elemente mit den gleichen Bezugszeichen versehen.

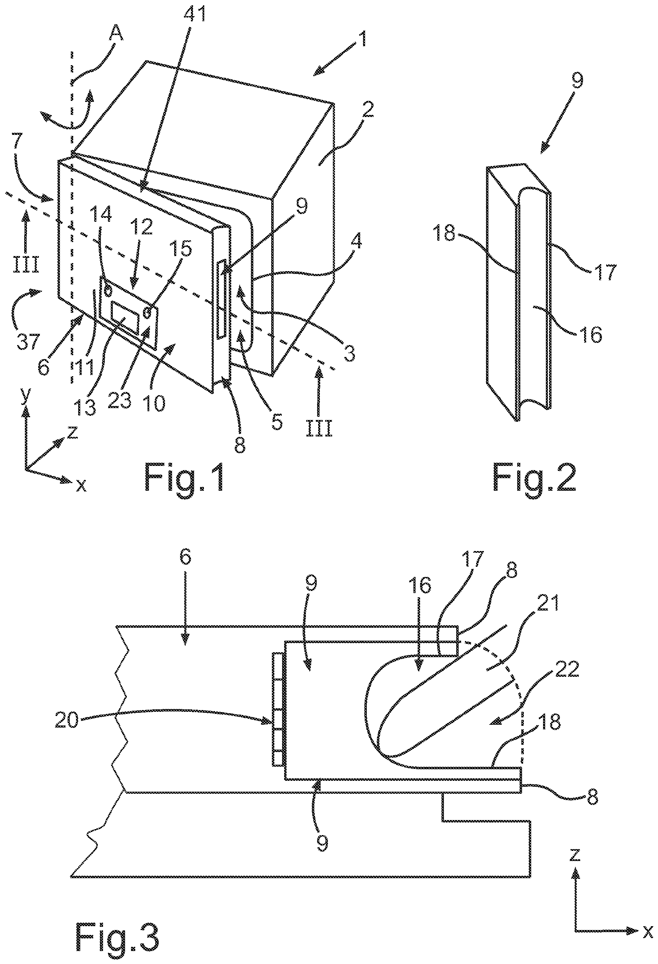

In Fig. 1 ist in vereinfachter perspektivischer Darstellung ein Backofen 1 gezeigt, welcher ein Gehäuse 2 aufweist. In dem Gehäuse 2 ist ein Garraum 3 ausgebildet, welcher durch eine Muffel 4 begrenzt ist. Eine frontseitige Beschickungsöffnung 5 ist durch eine Tür 6 verschließbar. Die Tür 6 ist im geöffneten Zustand gezeigt. Die Tür 6 ist um eine vertikale Längsachse A gemäß der Pfeildarstellung verschwenkbar. Die Tür 6 weist eine erste vertikale Längsseite 7 auf, an der Anschlagelemente angeordnet sind, mit welchen die Tür 6 an dem Gehäuse 2 befestigt ist und relativ gegenüber dem Gehäuse 2 bewegbar ist. Darüber hinaus weist die Tür 6 eine der ersten vertikalen Längsseite 7 gegenüber liegende zweite vertikale Längsseite 8 auf, in der im Ausführungsbeispiel ein Griffelement 9 ausgebildet ist. Darüber hinaus umfasst die Tür eine Oberseite 41. Es kann vorgesehen sein, dass an dieser Oberseite ein weiteres zusätzliches Griffelement angeordnet ist oder das optional das Griffelement 9 an dieser Oberseite 41 und nicht an der Längsseite 8 angeordnet ist. Die Tür 6 weist darüber hinaus eine Frontplatte 10 auf, wobei an einer Frontfläche 11 der Frontplatte 10 eine Bedieneinrichtung 12 ausgebildet ist. Die Bedieneinrichtung 12 umfasst eine Anzeigeeinheit 13 sowie in Form, Position und Anzahl lediglich beispielhaft gezeigte Bedienelemente 14 und 15. In der Tür 6 sind somit die Bedieneinrichtung 12 als auch das Griffelement 9 integriert.

In Fig. 2 ist in perspektivischer Darstellung das Griffelement 9 dargestellt. Es ist eine einstückig ausgebildete geradlinige Schiene, welche einen Eingriffsbereich 16 aufweist. Dieser ist als eckenfreie Griffmulde beziehungsweise Rinne ausgebildet, wobei parallel zueinander Rinnenschenkel 17 und 18 die Griffmulde beziehungsweise den Eingriffsbereich 16 begrenzen. Diesbezüglich ist das Griffelement 9 asymmetrisch ausgebildet, da der der Frontplatte 10 zugewandte Rinnenschenkel 18 länger ist beziehungsweise weiter sich nach vorne erstreckt als der der Frontplatte 10 abgewandte Rinnenschenkel 17.

In Fig. 3 ist ein schematischer Darstellung ein Schnitt entlang der Schnittlinie III/III in Fig. 1 gezeigt. Es ist zu erkennen, dass das Griffelement 9 in einem Schlitz 19 der Tür 6 integriert ist. Das Griffelement 9 ist somit quasi in die Tür 6 integriert und versenkt ausgebildet. An der Rückseite des Griffelements 9 ist zumindest eine Elektrode 20 eines kapazitiven Sensors ausgebildet, welcher ein Erkennungssensor ist. Mittels dem Erkennungssensor wird erkannt, ob sich ein Finger 21 in einen Detektionsbereich 22, der durch die gestrichelte Linie beispielhaft begrenzt ist, erstreckt und/oder ob der Finger 21, wie in Fig. 3 gezeigt, das Griffelement 9 berührt. Die Elektroden 20 können zusätzlich oder anstatt der gezeigten rückwärtigen Position auch an dem Griffelement 9 angeordnet sein oder in der Tür 6 integriert sein.

Die Informationen des Erkennungssensors werden an eine Steuereinheit 23 (Fig. 1), die in der Tür 6 oder an einer sonstigen Position im Gehäuse 2 angeordnet sein kann, übertragen, wobei die Steuereinheit 23 abhängig von den Informationen des Erkennungssensors eine Türöffnungsvorrichtung steuert, mittels welcher die Tür 6 automatisch geöffnet wird.

Wird erkannt, dass sich ein oder mehrere Finger 21 innerhalb des Detektionsbereichs 22 befinden oder ein Finger 21 mit dem Griffelement 9 kontaktiert ist, so wird diesbezüglich spätestens mit dem Kontaktieren des Griffelements 9 erkannt, dass ein Öffnungswunsch eines Nutzers vorliegt und über die Steuereinheit kann diesbezüglich sehr schnell darauf reagiert werden und die Türöffnungsvorrichtung angesteuert werden.

In der Darstellung gemäß Fig. 3 ist darüber hinaus zu erkennen, dass die Frontplatte 10 sich in x-Richtung soweit erstreckt, dass sie zumindest so lange ist wie der Schenkel 18 des Griffelements 9. Dadurch ist bei einer frontseitigen Betrachtung des Backofens 1 und somit auch bei einer frontseitigen Betrachtung der geschlossenen Tür 6 das Griffelement 9 durch die Frontplatte 10 verdeckt.

Das Griffelement 9 ist ortsfest und somit nicht relativ bewegbar gegenüber der Tür 6 an dieser positioniert. Das Griffelement 9 ist insbesondere in den Bereichen, in denen eine oder mehrere Elektroden 20 angeordnet sind, aus einem elektrisch nicht leitfähigen Material ausgebildet.

Der Backofen 1 kann über das Griffelement 9 zur automatischen Türöffnung betätigt werden oder darüber hinaus auch zusätzlich über die Bedieneinrichtung 12, wobei beispielsweise eine Taste 14 oder 15 betätigt wird, um die Ansteuerung der automatischen Türöffnungsvorrichtung zu bewirken. Durch diese Ausgestaltung kann der Nutzer auch bedürfnisabhängig individuell eine Konfiguration dahingehend vornehmen, ob eine Aktivierung und Ansteuerung der automatischen Öffnungsvorrichtung über das Griffelement 9 oder über die Bedieneinrichtung 12 erfolgen soll.

Vorzugsweise ist vorgesehen, dass der Antriebsmotor dann zum automatischen Öffnen der Tür 6 angesteuert wird, wenn das Griffelement 9 berührt ist, wenn die Tür 6 geschlossen ist und wenn der Pyrolysebetrieb des Backofens 1 nicht mehr aktiviert ist. Vorzugsweise ist vorgesehen, wenn die Tür 6 ohnehin geöffnet ist, dass der Antriebsmotor nicht aktiviert wird. Diesbezüglich ist er dann auch bei einem Greifen des Griffelements 9 zum weiteren Öffnen der Tür oder zum Schließen der Tür 6 deaktiviert.

Insbesondere ist auch vorgesehen, dass der Backofen 1 eine Kindersicherungseinrichtung aufweist, welche über die Bedieneinrichtung 12 aktivierbar und deaktivierbar ist. Ist die Kindersicherungseinrichtung aktiviert, so kann nicht automatisch durch das Greifen des Griffelements 9 im geschlossenen Zustand der Tür 6 die Ansteuerung der Türöffnungsvorrichtung erfolgen und auch nicht das einfache Aktivieren der Ansteuerung der automatischen Türöffnungsvorrichtung durch einfaches Betätigen eines Bedienelements 14 oder 15 erreicht werden. Erst dann, wenn die Kindersicherungseinrichtung wieder deaktiviert wird oder wenn spezifische weitere multipel kombinierbare Handlungen, beispielsweise Betätigung ein oder mehrer Bedienelemente 14 und 15 in spezifischer Art und Weise, durchgeführt werden, kann dann auch bei eingestellter Kindersicherungseinrichtung das Ansteuern der automatischen Türöffnungsvorrichtung erzielt werden.

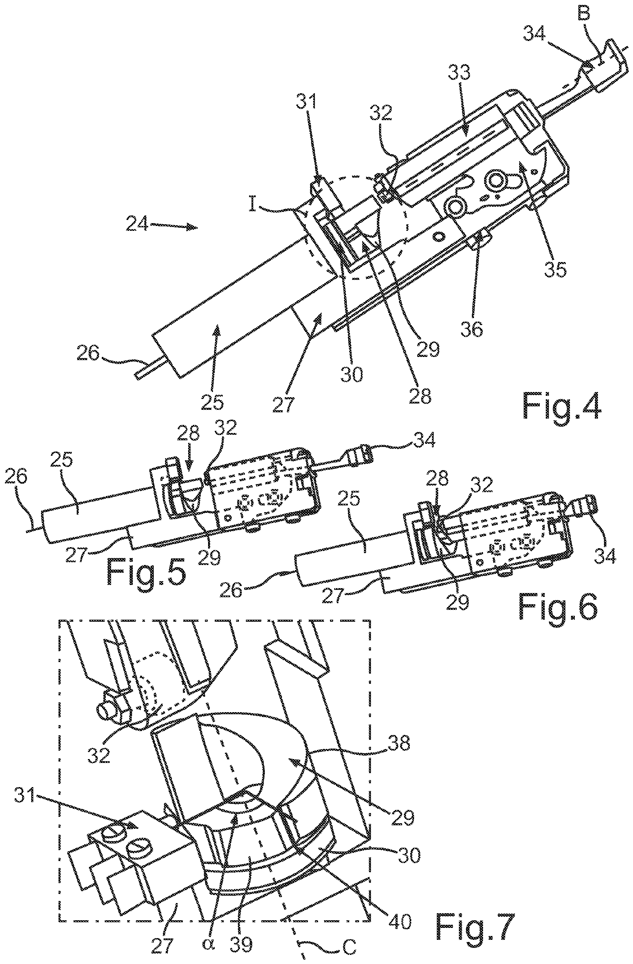

In Fig. 4 ist in einer perspektivischen Darstellung ein Ausführungsbeispiel einer Türöffnungsvorrichtung 24 gezeigt. Diese umfasst einen Antriebsmotor 25 mit einer Antriebswelle 26. Der Motor 25 ist an einem Motorträger 27 befestigt. Darüber hinaus umfasst die Türöffnungsvorrichtung 24 ein Nockenelement 28, welches hohlzylinderförmig ausgebildet ist und an seinen dem Motor 25 abgewandten Ende eine helixförmig ausgebildete Nockenbahn 29 aufweist. Das Nockenelement 29 und der Motor 25 sind durch ein Längskugellager beziehungsweise Axialkugellager 30 gelagert, mit welchem axiale Kräfte auf die Antriebswelle 26 vermieden werden.

Darüber hinaus umfasst die Türöffnungsvorrichtung einen elektronischen Schalter 31, welcher an dem Motorträger 27 angeordnet ist. Dieser Schalter 31 ist benachbart zum Nockenelement 28 angeordnet, wobei er zur Erfassung von Drehstellungen des Nockenelements 28 um die Drehachse, welche gleich der Achse der Antriebswelle 26 ist, ausgebildet ist. An der Nockenbahn 29 ist ein Übertragungselement 32 angreifend beziehungsweise abrollend, welches als Kugellager ausgebildet ist. Dieses Übertragungselement 32 ist mit einem Stößel 33 verbunden beziehungsweise an ihm befestigt. Der Stößel 33 ist in mechanischer Wirkverbindung mit einem Türhaken 34. Der Türhaken 34 wiederum ist mit einer Drehfalle 35 zum Erzeugen des verriegelten Zustands der Tür 6 verbunden. Der Stößel 33, der Motorträger 27, die Drehfalle 35 und gegebenenfalls auch weitere Komponenten sind in einem Gehäuse 36 der Türöffnungsvorrichtung 24 angeordnet. Durch diese konzeptionelle Ausgestaltung der Türöffnungsvorrichtung 24 kann eine rotatorische Bewegung des Motors 25, insbesondere der Antriebswelle 26 auf das Nockenelement 28 übertragen werden, wobei aufgrund der spezifischen Formgebung des Nockenelements 28 mit der helixförmigen Nockenbahn 29 diese rotatorische Bewegung in eine Linearbewegung des Stößels 33 und somit auch des Türhakens 34 umgewandelt werden kann. Der Türhaken 34 wird somit lediglich linear in Richtung der Achse B bewegt.

In Fig. 5 ist in einer perspektivischen Darstellung von unten die Türöffnungsvorrichtung 24 gezeigt. Dabei ist eine erste Betriebsstellung gezeigt, nämlich die Endstellung des Nockenelements 28, bei dem das Übertragungselement 32 analog zur Darstellung in Fig. 4 am obersten Ende der Nockenbahn 29 angelangt ist.

In Fig. 6 ist in analoger Darstellung zur Fig. 5 eine perspektivische Ansicht von unten auf die Türöffnungsvorrichtung 24 gezeigt, wobei diesbezüglich ein weiterer Betriebszustand dargestellt ist. In Fig. 6 ist die Grundstellung des Nockenelements 28 gezeigt, wobei dabei das Übertragungselement 32 an der untersten Stelle der Nockenbahn 28 angelangt ist.

Der Motor 25 ist mit der Steuereinheit 23 elektrisch verbunden und wird über diese angesteuert.

Die Steuereinheit 23 und die Türöffnungsvorrichtung 24 sind mit der Tür 6 einer Türvorrichtung 37 (Fig. 1) zugehörig.

In Fig. 7 ist ein vergrößerter Ausschnitt I der Darstellung in Fig. 4 gezeigt. Die Darstellung ist dabei gegenüber der Ansicht in Fig. 4 etwas gedreht. Es ist sowohl der Schalter 31 an dem Motorträger 27 als auch die spezifische Position zum Nockenelement 28 zu erkennen. Das Nockenelement 28 ist um seine Längsachse C durch die Kopplung mit der Antriebswelle 26 drehbar, wobei zwischen der Ausgangsstellung beziehungsweise Grundstellung und der Endstellung lediglich eine volle Umdrehung um die Achse C durchgeführt wird. An einer Mantelfläche 38 des Nockenelements 28 ist eine Erhebung 39 ausgebildet. In Umlaufrichtung ausgehend von der in Fig. 7 gezeigten Ausgangsstellung erstreckt sich die Erhebung 39 bis zu einem Ende 40. Dieses Ende 40 definiert auch das Ende eines ersten Drehstellungsintervalls, welches sich von der Ausgangsstellung bis zu dieser durch das Ende 40 definierten Drehzwischenstellung erstreckt. Diese Zone beziehungsweise dieses Drehstellungsintervalls ist zwischen den lediglich beispielhaft eingezeichneten Linien, welche bei der tatsächlichen Ausführung nicht dargestellt sind und lediglich die Grenzen des erste Drehstellungsintervalls und somit den Winkelbereich α zeigen, dargestellt. Innerhalb dieses Winkelbereichs a, welcher das erste Drehstellungsintervall kennzeichnet, kann der Schalter 31 diese Position genau erfassen, indem er die Erhebung 39 detektiert. Solange sich das Nockenelement 28 innerhalb dieses ersten Drehstellungsintervalls relativ zum Erfassungsbereich des Schalters 31 befindet, wird die Nullstellung des Motors 25 erkannt und die weitere Bewegung des Motors 25 gestoppt. In dieser Position des Motors 25 und somit auch des Nockenelements 28 ist sicher gewährleistet, dass die Tür 6 wieder manuell vollständig geschlossen werden kann. Befindet sich das Nockenelement 28 außerhalb dieses ersten Drehstellungsintervalls und befindet sich somit in einer Drehstellung zwischen der Drehzwischenstellung, welche am Ende des Winkelbereichs α beginnt, und einer Endstellung des Nockenelements 28 (zweites Drehstellungsintervall), so kann eine vollständige Türschließung nicht erfolgen. Der Motor 25 wird dann in seine Nullstellung gebracht was wiederum über das Nockenelement 28 und den Schalter 31 erkannt wird. Ein zu weites Drehen oder zu wenig weites Drehen des Nockenelements 28 und des Motors 25 kann dadurch vermieden werden. Durch diese Verbringung des Nockenelements 28 und des Motors 25 innerhalb des ersten Drehstellungsintervalls wird verhindert, dass das Übertragungselement 32 bei Schließen der Tür 6 und somit beim Bewegen des Türhakens 34 in Richtung des Nockenelements 28 zu früh an die Nockenbahn 29 kontaktiert und nicht weiter bewegt werden kann. Die Länge der Nockenbahn 29 im ersten Drehstellungsintervall, welches durch den Winkelbereich α gekennzeichnet ist, ist wesentlich kleiner als der Teilausschnitt der Nockenbahn 29, über den sich das zweite Drehstellungsintervall erstreckt.

Lediglich der Türhaken 34 ist an der Tür 6 befestigbar, wohingegen die weiteren Komponenten im Gehäuse 2 separat zur Tür 6 angeordnet sind. Die Türöffnungsvorrichtung 24 ist an einem unteren Verschluss der Tür 6 ausgebildet.

Durch die Erhebung 39 wird praktisch der Schalter 31 eingeschaltet und damit dieses erste Drehstellungsintervall erkannt. Der Motor 25 wird gestoppt, wenn er eine Information über beispielsweise eine Impulsflanke von dem Schalter 31 empfängt. Der Schalter 31 erkennt die Winkelposition des Nockenelements 28. Um den Motor 25 schnell stoppen zu können, beispielsweise wenn die automatische Türöffnung durch ein Zuhalten oder ein daran Anlehnen eines Nutzers unbeabsichtigt erfolgt, wird der Motor 25 kurzgeschlossen.

### Bezugszeichenliste

- 1: Backofen
- 2: Gehäuse
- 3: Garraum
- 4: Muffel
- 5: Beschickungsöffnung
- 6: Tür
- 7, 8: Längsseiten
- 9: Griffelement
- 10: Frontplatte
- 11: Frontfläche
- 12: Bedieneinrichtung
- 13: Anzeigeeinheit
- 14, 15: Bedienelemente
- 16: Eingriffsbereich
- 17, 18: Rinnenschenkel
- 20: Elektrode
- 21: Finger
- 22: Detektionsbereich
- 23: Steuereinheit
- 24: Türöffnungsvorrichtung
- 25: Antriebsmotor
- 26: Antriebswelle
- 27: Motorträger
- 28: Nockenelemente
- 29: Nockenbahn
- 30: Axialkugellager
- 31: Schalter
- 32: Übertragungselement
- 33: Stößel
- 34: Türhaken
- 35: Drehfalle
- 36: Gehäuse
- 37: Türvorrichtung
- 38: Mantelfläche
- 39: Erhebung
- 40: Ende
- 41: Oberseite
- A, B, C: Achsen
- α: Winkelbereich

## Patentansprüche

1. Türvorrichtung für ein Hausgerät (1), mit einer Tür (6), einem Griffelement (9) und mit einer Türöffnungsvorrichtung (24) zum automatischen Öffnen der Tür (6), wobei die Tür (6) zumindest einen Erkennungssensor (20) aufweist, welcher zur Erfassung eines Fingers (21) in einem Detektionsbereich (22) um das oder an dem Griffelement (9) ausgebildet ist, und eine Steuereinheit (23) ausgebildet ist, welche abhängig von den Informationen des Erkennungssensors (20) zur Steuerung der Türöffnungsvorrichtung (24) ausgebildet ist, wobei die Tür (6) eine erste vertikale Längsseite (7), eine der ersten Längsseite (7) gegenüberliegende zweite vertikale Längsseite (8) und eine sich zwischen den Längsseiten erstreckende Oberseite (41) aufweist und die Längsseite (7, 8) und die Oberseite (41) durch die Flächen definiert sind, welche sich durch die Dicke der Tür (6) hinter einer Frontfläche (11) der Tür (6) nach hinten ergeben, **dadurch gekennzeichnet, dass** an der zweiten Längsseite (8) ein Griffelement (9) und/oder an der Oberseite (41) ein Griffelement (9) ausgebildet ist, wobei an der zweiten Längsseite (8) und/oder an der Oberseite (41) ein Schlitz (19) ausgebildet ist, in dem das Griffelement (9) angeordnet ist.

2. Türvorrichtung nach Anspruch 1, **dadurch gekennzeichnet, dass** das Griffelement (9) eine Leiste ist, welche einen Eingriffsbereich (16), insbesondere eine eckenfreie Rinne, aufweist.

3. Türvorrichtung nach Anspruch 2, **dadurch gekennzeichnet, dass** ein einer Türfront (11) zugewandter Rinnenschenkel (18) länger ausgebildet ist als ein der Türfront (11) abgewandter Rinnenschenkel (17).

4. Türvorrichtung nach einem der vorhergehenden Ansprüche, **dadurch gekennzeichnet, dass** das Griffelement (9) bei frontseitiger Betrachtung der Tür (6) hinter einer Frontplatte (10) der Tür (6) angeordnet und durch diese verdeckt ist.

5. Türvorrichtung nach einem der vorhergehenden Ansprüche, **dadurch gekennzeichnet, dass** der Erkennungssensor (20) ein kapazitiver Sensor ist.

6. Türvorrichtung nach einem der vorhergehenden Ansprüche, **dadurch gekennzeichnet, dass** in der Tür (6) hinter dem Griffelement (9), insbesondere an dem Griffelement (9) hinter einem Eingriffbereich (16), eine Elektrode (20) des Sensors angeordnet ist.

7. Türvorrichtung nach einem der vorhergehenden Ansprüche, **dadurch gekennzeichnet, dass** das Griffelement (9) zumindest im Bereich des Erkennungssensors (20) aus einem elektrisch nicht leitenden Material ausgebildet ist.

8. Türvorrichtung nach einem der vorhergehenden Ansprüche, **dadurch gekennzeichnet, dass** die automatische Türöffnungsvorrichtung (24) eine Kindersicherungseinrichtung aufweist.

9. Türvorrichtung nach einem der vorhergehenden Ansprüche, **dadurch gekennzeichnet, dass** die Tür (6) eine Bedieneinrichtung (12) aufweist, welche an einer Frontplatte (10) der Tür (6) ausgebildet ist.

10. Türvorrichtung nach Anspruch 8 und 9, **dadurch gekennzeichnet, dass** die Kindersicherungseinrichtung über die Bedieneinrichtung (12) elektronisch gesteuert durch die Steuereinheit (23) aktivierbar und deaktivierbar ist.

11. Türvorrichtung nach Anspruch 9 oder 10, **dadurch gekennzeichnet, dass** die Türöffnungsvorrichtung (24) auch über die Bedieneinrichtung (12) betätigbar ist.

12. Türvorrichtung nach einem der vorhergehenden Ansprüche, **dadurch gekennzeichnet, dass** die Türöffnungsvorrichtung (24) einen Türhaken (34) aufweist, welcher an der Tür (6) angeordnet ist, und welcher mittels einer separat zur Tür (6) angeordneten Antriebsvorrichtung der Türöffnungsvorrichtung (24) linear betätigbar und mit einer Antriebsvorrichtungsseitig angeordneten Drehfalle (35) zum Öffnen der Tür (6) entriegelbar ist.

13. Hausgerät, insbesondere Backofen (1), mit einer Türvorrichtung nach einem der vorhergehenden Ansprüche.

14. Verfahren zum Betätigen einer Türvorrichtung nach einem der vorangehenden Ansprüche 1-13, wobei ein Finger (21) in einem Detektionsbereich (22) um das oder an dem Griffelement (9) durch zumindest einen Erkennungssensor (20) der Türvorrichtung erfasst wird und das Öffnen der Tür (6) abhängig von den Informationen des Erkennungssensors (20) durch eine Steuereinheit (23) gesteuert wird.

## Claims

1. Door device for a domestic appliance (1) comprising a door (6), a handle element (9) and a door-opening device (24) for automatic opening of the door (6), wherein the door (6) has at least one detection sensor (20) configured for detecting a finger (21) in a detection region (22) around or at the handle element (9), and a control unit (23) is provided which is configured dependent on the information from the detection sensor (20) for controlling the door-opening device (24), wherein the door (6) has a first vertical longitudinal side (7), a second vertical longitudinal side (8) arranged opposite the first vertical longitudinal side (7) and an upper side (41) extending between the longitudinal sides, and the longitudinal side (7, 8) and the upper side (41) are defined by the surfaces which result from the thickness of the door (6) extending rearwardly behind a front surface (11) of the door (6), **characterised in that** a handle element (9) is arranged at the second longitudinal side (8) and/or at the upper side (41), wherein arranged at the second longitudinal side (8) and/or at the upper side (41) is a slit (19) in which a handle element (9) is arranged.

2. Door device according to claim 1, **characterised in that** the handle element (9) is a bar which has an engagement region (16), in particular a corner-free channel.

3. Door device according to claim 2, **characterised in that** a channel limb (18) facing a door front (11) is configured longer than a channel limb (17) facing away from the door front (11).

4. Door device according to one of the preceding claims, **characterised in that**, when viewing the door (6) from the front side, the handle element (9) is arranged behind the front panel (10) of the door (6) and is concealed thereby.

5. Door device according to one of the preceding claims, **characterised in that** the detection sensor (20) is a capacitive sensor.

6. Door device according to one of the preceding claims, **characterised in that** an electrode (20) of the sensor is arranged in the door (6) behind the handle element (9), in particular at the handle element (9) behind an engagement region (16).

7. Door device according to one of the preceding claims, **characterised in that** the handle element (9) is made, at least in the region of the detection sensor (20), from an electrically non-conductive material.

8. Door device according to one of the preceding claims, **characterised in that** the automatic door-opening device (24) has a child safety device.

9. Door device according to one of the preceding claims, **characterised in that** the door (6) has an operating device (12) provided at a front panel (10) of the door (6).

10. Door device according to claim 8 and 9, **characterised in that** the child safety device can be activated and deactivated via the operating device (12), electronically controlled by the control unit (23).

11. Door device according to claim 9 or 10, **characterised in that** the door-opening device (24) can also be actuated via the operating device (12).

12. Door device according to one of the preceding claims, **characterised in that** the door-opening device (24) has a door hook (34) which is arranged at the door (6) and which is linearly actuatable by means of a drive device of the door-opening device (24) provided separately from the door (6) and which can be unlocked with a rotary catch (35) arranged on the drive device side for opening the door (6).

13. Domestic appliance, in particular oven (1), comprising a door device according to one of the preceding claims.

14. Method for actuating a door device according to one of the preceding claims 1 - 13, wherein a finger (21) in a detection region (22) around or at the handle element (9) is detected by at least one detection sensor (20) of the door device and opening of the door (6) is controlled by a control unit (23) dependent on the information from the detection sensor (20).

## Revendications

1. Dispositif de porte pour un appareil ménager (1), avec une porte (6), un élément de poignée (9) et avec un dispositif d'ouverture de porte (24) pour l'ouverture automatique de la porte (6), dans lequel la porte (6) présente au moins un capteur de détection (20), exécuté afin de percevoir un doigt (21) dans une zone de détection (22) autour de l'élément de poignée (9) ou sur celui-ci, et une unité de commande (23) est exécutée, laquelle est exécutée afin de commander le dispositif d'ouverture de porte (24) en fonction des informations du capteur de détection (20), dans lequel la porte (6) présente un premier côté longitudinal vertical (7), un deuxième côté longitudinal vertical (8) opposé au premier côté longitudinal (7) et un côté supérieur (41) s'étendant entre les côtés longitudinaux et le côté longitudinal (7, 8) et le côté supérieur (41) sont définis par les surfaces constituées par l'épaisseur de la porte (6) derrière une surface frontale (11) de la porte (6) en direction de l'arrière, **caractérisé en ce qu'**un élément de poignée (9) est exécuté sur le deuxième côté longitudinal (8) et/ou un élément de poignée (9) est constitué sur le côté supérieur (41), une fente (19) dans laquelle l'élément de poignée (9) est disposé étant exécutée sur le deuxième côté longitudinal (8) et/ou sur le côté supérieur (41).

2. Dispositif de porte selon la revendication 1, **caractérisé en ce que** l'élément de poignée (9) est une moulure présentant une zone de prise (16), en particulier un chenal sans angle.

3. Dispositif de porte selon la revendication 2, **caractérisé en ce qu'**une branche de chenal (18) dirigée vers une face de porte (11) est exécutée plus longue qu'une branche de chenal (17) écartée de la face de porte (11).

4. Dispositif de porte selon l'une des revendications précédentes, **caractérisé en ce que** l'élément de poignée (9) est disposé derrière une plaque frontale (10) de la porte (6) et masqué par celle-ci lorsque la porte (6) s'observe de face.

5. Dispositif de porte selon l'une des revendications précédentes, **caractérisé en ce que** le capteur de détection (20) est un capteur capacitif.

6. Dispositif de porte selon l'une des revendications précédentes, **caractérisé en ce qu'**une électrode (20) du capteur est placée dans la porte (6) derrière l'élément de poignée (9), en particulier sur l'élément de poignée (9) derrière une zone de prise (16).

7. Dispositif de porte selon l'une des revendications précédentes, **caractérisé en ce que** l'élément de poignée (9) est exécuté, au moins dans la zone du capteur de détection (20), en un matériau électriquement non conducteur.

8. Dispositif de porte selon l'une des revendications précédentes, **caractérisé en ce que** le dispositif d'ouverture de porte automatique (24) présente une sécurité enfants.

9. Dispositif de porte selon l'une des revendications précédentes, **caractérisé en ce que** la porte (6) présente un dispositif de manoeuvre (12) exécuté sur une plaque avant (10) de la porte (6).

10. Dispositif de porte selon la revendication 8 et 9, **caractérisé en ce que** la sécurité enfants est activable et désactivable sous pilotage électronique par l'unité de commande (23) via le dispositif de manoeuvre (12).

11. Dispositif de porte selon la revendication 9 ou 10, **caractérisé en ce que** le dispositif d'ouverture de porte (24) est également actionnable via le dispositif de manoeuvre (12).

12. Dispositif de porte selon l'une des revendications précédentes, **caractérisé en ce que** le dispositif d'ouverture de porte (24) présente un crochet de porte (34) disposé sur la porte (6) et actionnable linéairement au moyen d'un dispositif d'entraînement du dispositif d'ouverture de porte (24) disposé séparément de la porte (6) et déverrouillable avec un pêne rotatif (35) pour l'ouverture de la porte (6) disposé du côté du dispositif d'entraînement.

13. Appareil ménager, en particulier four (1), avec un dispositif de porte selon l'une des revendications précédentes.

14. Procédé d'actionnement d'un dispositif de porte selon l'une des revendications précédentes 1 à 13, dans lequel au moins un capteur de détection (20) du dispositif de porte perçoit un doigt (21) dans une zone de détection (22) autour de l'élément de poignée (9) ou sur celui-ci et l'ouverture de la porte (6) est commandée par une unité de commande (23) en fonction des informations du capteur de détection (20).
